# EUROPEAN PATENT SPECIFICATION

(11) **EP 3 749 795 B1**
(45) Date of publication and mention of the grant of the patent: **08.12.2021**
(21) Application number: 19714864.6
(22) Date of filing: 05.02.2019
(51) Int. Cl.: C23C 14/04, B23K 26/02, B23K 26/06, C23C 14/28, C23C 14/54, B23K 26/073, B23K 26/082, H01L 21/02

(54) **LIFT DEPOSITION APPARATUS AND METHOD**
LIFT BESCHICHTUNGSVORRICHTUNG UND VERFAHREN
APPAREIL ET PROCÉDÉ DE DÉPÔT PAR LIFT

(30) Priority: 06.02.2018 EP 18155325
(43) Date of publication of application: 16.12.2020
(73) Proprietor: Nederlandse Organisatie voor toegepast- natuurwetenschappelijk Onderzoek TNO, 2595 DA 's-Gravenhage (NL)
(72) Inventor: ARUTINOV, Gari, 2595 DA 's-Gravenhage (NL)
(74) Representative: V.O.
(86) International application number: PCT/NL2019/050070
(87) International publication number: WO 2019/156555

(56) References cited:
- WO-A2-2009/081355
- US-A1- 2003 178 395
- US-A1- 2009 074 987

## Description

### BACKGROUND OF THE INVENTION

### Field of the invention

The present invention pertains to a deposition apparatus.

The present invention still further pertains to a deposition method.

### Related Art

Laser induced forward transfer (LIFT) is an emerging high resolution technology wherein a donor material is transferred from a donor source substrate to a target substrate. LIFT renders it possible to deposit a wide range of structural and functional materials without the use of a nozzle. In this technology an optical beam is directed through a donor substrate to a layer of donor material on the donor substrate. The radiation energy of the optical beam has the effect that a portion of the donor material is released and is transferred to a surface of the target substrate. This renders it possible to form electrically conductive elements, such as electrically conductive tracks or connections at the surface of the target substrate or to fill through silicon via's (TSVs) inside the target substrate.

For example WO2011/145930 proposes a chip die TSV treatment apparatus arranged for treatment of TSVs in chip dies in a chip manufacturing process. The known apparatus is dedicated to the latter purpose. It is noted further that WO 2009/081355 A2 pertains to a direct write method. Therein an optical assembly is configured to direct a writing laser and a tracking laser. A carrier has a material layer and a tracking layer. The carrier is moveable relative to the optical assembly such that when the material layer is energized by the writing laser, direct writing is provided to a surface below the carrier. The tracking layer includes readable data which is employed to control one of the optical assembly and a position of the carrier.

It is still further noted that US 2003/178395 A1 discloses an apparatus for fabrication of miniature structures that includes a substrate, a source of energy capable of generating an energy or energetic beam, a material carrier element displaceably disposed in a gap formed between the source of energy and the substrate, a deposition layer supported on the backing material of the material carrier element, and a control unit operatively coupled to the source of energy through the communication link and to the material carrier element through the communication link. Alternatively, the control unit may be operatively coupled to the substrate.

Practical applications are often more complicated, because a surface of a target substrate may not be flat, but may have edges. It may further be desired to provide the target substrate with mutually different types of electrically conductive elements, including not only electrical connections at the target substrate surface, but also electrical connections in the form of a filling to form through silicon via's (TSVs). There is a need for an apparatus and method that are more suitable for these more complicated applications.

### SUMMARY OF THE INVENTION

In accordance with the above-mentioned need, it is a first object of the invention to provide a deposition method that is better configured for one or more of the above-mentioned applications.

In accordance with the above-mentioned need, it is a second object of the invention to provide a deposition apparatus that is better configured for one or more of the above-mentioned applications.

According to the first object an improved apparatus is provided as claimed in claim 1 and in accordance with the second object an improved method is provided as claimed in claim 8.

Contrary to the method and apparatus known from the prior art, the optical beam is not merely positioned to a location of the donor substrate from which the donor material is to be ejected, but in addition a spatial energy distribution of the beam is controlled to provide for a transfer of the donor material as a jet. In particular this is achieved by controlling the optical beam with a substantially asymmetric spatial distribution on the basis of a shape to be assumed by the jet according to said specification data, therewith increasing the versatility of the method. It is noted that the spatial energy distribution is defined herein as the distribution of the radiation energy of a radiation dose with which a portion of donor material is transferred. The spatial energy distribution results from an integration of the power density distribution over a time-interval during which the dose is supplied. The power density distribution may be modulated during this time-interval, but may alternatively remain constant.

In the claimed deposition method, with the claimed apparatus, the intensity profile of the optical beam is deliberately controlled to determine how portions of the donor material are ejected from the donor substrate. Upon directing the optical beam via the donor substrate a force pattern is exerted to the donor material having a spatial distribution corresponding to the spatial energy distribution.

Upon ejection, the ejected material has a momentum pattern corresponding to the force pattern induced by the optical beam. At positions where the optical beam has a relatively high intensity the viscous donor material is accelerated to a speed that is higher than at positions where the optical beam has a relatively low intensity. As a result, a deformation of the ejected material occurs during its traversal of the space between the donor substrate and the target substrate.

In one embodiment the force pattern originates from evaporation of donor material that is heated by absorbed radiation of the optical beam. In another embodiment this force pattern originates from evaporation of material of an intermediate layer, also denoted as dynamic release layer DRL, arranged between the substrate and the layer of donor material. The nature of the force pattern further depends on a duration of the exposure to the beam. If optical radiation is provided as a pulse with a relatively long duration at a relatively low power a more smooth spatial force distribution will be obtained than in case the optical radiation is provided as a pulse with a relatively short duration at a relatively high power. According to have optimum control over the shape of the jet of donor material, the pulse duration preferably is in the picosecond range. E.g. in the range of 10 to 500 ps. Nevertheless alternative embodiments are possible wherein the pulse duration may be longer, for example in cases wherein a portion of donor material having a larger surface area is to be ejected. At present good experimental results are achieved with a pulse duration in the ns range, i.e. with a duration of about 10 ns. The relatively long duration of the pulse causes an ejection of donor material from a relatively large area of the donor substrate. Accordingly, the duration of the pulse applied to eject donor material may be used as a control parameter to determine a size of the area of the donor substrate to be ejected as an alternative or in addition to change a size of the radiation beam. It may also be contemplated to provide a pulse train with a series of relatively short pulses, for example a pulse train having a total duration of a few ns comprising a plurality of pulses with a duration of a few tens or hundreds of pc.

A viscous donor material is considered a non-solid material having a relatively high viscosity, for example in a range of 1-10 Pas. In this context a relatively high viscosity is understood to be a viscosity low enough to enable a shape deformation of ejected portions of the material. On the other hand the viscosity of the material should be sufficiently high to avoid a too rapid change of shape of the material in the time interval wherein the ejected material moves from the surface of the donor substrate to the surface of the target substrate.

In practice the surface tension of the donor material proves to be only of secondary importance. If the surface tension is relatively low e.g. lower than about 20 dyn/cm then in particular for thicker donor layers, the jet may have a tendency to disintegrate. This can be avoided by ejection of the donor material using a spatial energy distribution which has a higher average energy density in a ring shaped zone around its optical axis than an average energy density within an inner boundary of the ring shaped zone.

It is further noted that rheological properties of the donor material may be modified by additives or solvent, for example to obtain a shear-thickening, a shear-thinning, a thixotropic, a rheopectic or a Bingham plastic behavior. In particular donor materials with a shear-thinning behavior are favorable. Donor materials with this behavior have a viscosity that decreases with the rate of shear strain. Shear-thinning donor materials remain as a stable layer on the donor substrate, but are relatively easily morphed at the time of deposition.

### BRIEF DESCRIPTION OF THE DRAWINGS

These and other aspects are described in more detail with reference to the drawing. Therein:
FIG. 1 schematically shows a deposition apparatus according to a first embodiment,
FIG. 1A schematically shows a part of a second embodiment of the deposition apparatus,
FIG. 2 schematically shows a deposition apparatus according to a third embodiment,
FIG. 2A shows a part of this embodiment in more detail,
FIG. 3A and FIG. 3AA show an example of an applied intensity profile in more detail, therein FIG. 3AA shows an intensity distribution of the radiation beam in the x-y plane coinciding with the donor substrate and the main drawing of FIG. 3A shows the intensity distribution along the dashed line parallel to the y-axis,
FIG. 3B shows a picture of a jet of donor material, taken shortly after impingement of the radiation beam,
FIG. 4A- 4G schematically show a development of a jet of ejected donor material in time, when an intensity distribution as shown in FIG. 4 is used,
FIG. 5B shows a shape of a jet of ejected donor material at a fixed point in time in a series of experiments using the intensity distribution of FIG. 5A, 5AA,
FIG. 6B shows a shape of a jet of ejected donor material at a fixed point in time in a series of experiments using the intensity distribution of FIG. 6A, 6AA.

### DETAILED DESCRIPTION OF EMBODIMENTS

Like reference symbols in the various drawings indicate like elements unless otherwise indicated.

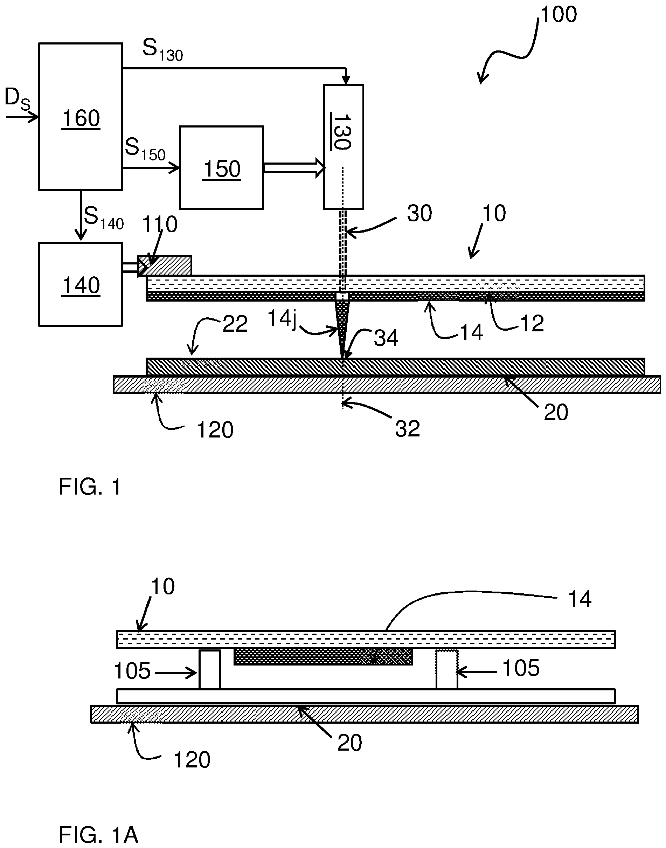

FIG. 1 schematically shows an embodiment of a deposition apparatus 100 to deposit donor material 14 having viscoelastic properties from a donor surface 12 of a donor substrate 10 on a target surface 22 of a target substrate 20. Dependent on the application, the donor material 14 may for example be provided as a layer of a few micron to few hundred micron on the donor surface 12. For example the layer may have a thickness of a few tens of micron, e.g. 40 micron.

The apparatus 100 as shown in FIG. 1 comprises a target substrate carrier 120 to carry the target substrate 20 and a donor substrate carrier 110 to carry the donor substrate 10 opposite the target substrate 20. The target substrate 20 and the donor substrate 10 are carried with the donor surface 12 and the target surface 22 facing each other. The target substrate 20 may be held at a distance from the donor substrate 10, which may be in a range of a few tenths of microns up to few millimeters and in extreme cases the donor substrate and the target substrate may even be placed a few centimeter apart.

The donor material is a visco-elastic material, typically paste like materials. These materials do not easily break into separate droplets. For example viscous inks and pastes, containing a high metal load of Cu or Ag nano- or micronparticles, or a conductive adhesive may be used.

The apparatus further comprises an optical beam generator 130 to generate an optical beam 30 to be directed through the donor substrate 10 towards the donor material 14. The optical beam has an optical axis 32 with a point of intersection 34 in the target surface 22. The apparatus includes a positioning device 140 to control a position of the point of intersection 34. As shown in FIG. 1 the apparatus can control the position of the point of intersection in this embodiment by controlling a position where the optical beam generator 130 projects the beam. Alternatively, the apparatus may include a positioning device to control a position of the target substrate. In again another embodiment the apparatus may include a positioning device 150 and a target substrate positioning device for the target substrate. For example, it may comprise the target substrate positioning device for a course positioning of the position of the point of intersection 34 and the positioning device 150 for the purpose of fine positioning. The position device 150 may for example be a fast beam modulator such as a galvano mirror, a polygon mirror, an acousto-optic or electro-optic modulator.

In the embodiment shown, the apparatus further includes a positioning device 140 to position the donor substrate carrier 110.

As shown in FIG. 1, the apparatus further comprises a controller 160 to control operation of the optical beam generator 130, and the positioning devices 140, 150 respectively.

In an operational state of the deposition apparatus 100, the controller 160 is configured to receive specification data Ds specifying a desired spatial distribution of donor material on the target surface 22. The specification data Ds may for example be retrieved from a memory unit or via a communication channel from a host processor. The specification data may specify a desired distribution of donor material on the target substrate 20, for example in the form of electrically conductive tracks on the target substrate, as electrical connections functional elements as a filling to form through silicon via's (TSVs).

In the operational state, the controller 160 generates position control signals S₁₄₀, S₁₅₀ to control the positioning devices 140, 150, and a beam generator control signal S₁₃₀ to control operation of the optical beam generator 130 in accordance with the spatial distribution specified by the specification data Ds. In response to the beam generator control signal S₁₃₀ the optical beam generator 130 generates the optical beam 30. When the optical beam 30 impinges on the donor substrate it causes donor material to be transferred as a jet 14j from the donor surface 12 towards a position on the target surface 22 dependent on the position control signal S₁₅₀.

The optical beam generator 130 is further configured to generate the optical beam 30 to eject a portion of donor material with a controllable spatial energy distribution. Furthermore, the controller 160 is configured to generate the beam generator control signal S₁₃₀ in accordance with the received specification data Ds to control the spatial energy distribution.

In an embodiment the controller 160 is configured to issue a beam generator control signal S₁₃₀ that causes the optical beam generator 130 to generate the optical beam with a spatial energy distribution that has a higher average energy density in a ring shaped zone 30r around its optical axis than an average energy density within an inner boundary 30ri of the ring shaped zone. In this manner is achieved that the ejected material better stays together than is the case with operation with a gaussian or uniform shaped beam. For example the ring shaped pattern may have a width/diameter ratio in the range of 1/10 to 1/5 and the diameter may be in the order of 50 to 500 micron. For example the radiation beam ring has a diameter of approximately 150 micron and a width of a approximately 20 micron. Accordingly the radiation energy density is relatively low in an inner area with a diameter of 110 micron in that example.

A setting of the laser fluence/energy leading to a stable nice jet depends on layer thickness. A thicker layer typically requires more energy, but allows longer and more stable jets. If a very high resolution is required a smaller thickness of the donor layer is recommended and consequently a lower laser energy should be applied. The laser energy is defined here as the total energy used to release a portion of the donor material from the donor surface.

Alternatively or additionally, the controller 160 may be configured to issue a beam generator control signal S₁₃₀ that causes the optical beam generator 130 to generate the optical beam 30 with a substantially asymmetric spatial distribution. Therewith an improved coverage of the donor material at edges on the target substrate can be achieved. In a ring-shaped energy distribution the ringshaped beam for example has an increased intensity in an angular portion of for example 10 to 90 degrees, for example within a region of about 50 degrees.

FIG. 1A shows a portion of an alternative embodiment, wherein the donor substrate 10 is maintained at a fixed position with respect to the target substrate 20 by means of shims or spacers 105.

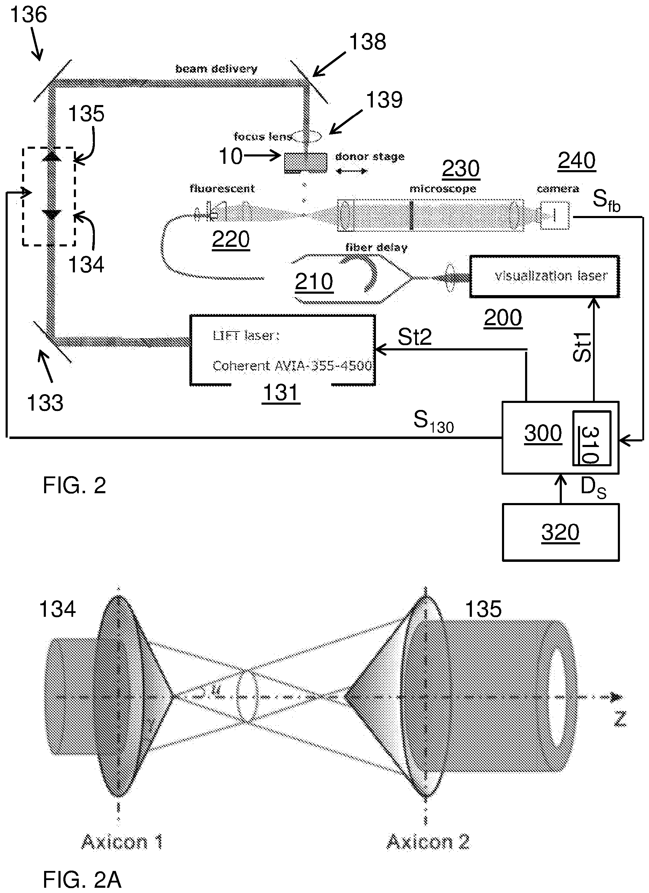

FIG. 2 schematically shows an assembly comprising an embodiment of the deposition apparatus and a monitoring apparatus for monitoring the deposition process in an operational state of the deposition apparatus. FIG. 2A shows a portion of the deposition apparats in more detail.

In the embodiment shown, the optical beam generator of the deposition apparatus comprises a main optical source 131 to generate a beam of coherent optical radiation and a beam shaper. In the embodiment shown, the main optical source 131 is a laser of type AVIA-335-4500. In this example, as shown in more detail in FIG. 2A, the beam shaper includes a first and a second axicon 134, 135. The beam shaper 134, 135 is controlled by signal S₁₃₀ from controller 300. The controller controls the apparatus on the basis of specification data Ds retrieved from a memory unit 320. In response to the control signals 130, a distance along the optical path between the first and the second axicon is set to scale the size of the ring-shaped beam. Furthermore an asymmetric intensity profile may be obtained by shifting one of the axicons for example the second axicon in a direction away from the optical axis. Additional optical elements may be provided, such as a beam-director 138 and one or more other optical elements to focus the beam on the donor substrate 10.
Alternatively another type of beam shaper may be provided such as a digital micromirror device (DMD). In a still further embodiment a beam shaper may be integrated in the optical source, for example inside a cavity of a laser serving as the optical source.

In the embodiment shown, the monitoring apparatus is provided as a shadowgraphy arrangement that comprises a further optical source 200 of radiation, an a microscopy camera arrangement with a microscope 230 and a camera 240. The further optical source 210 generates an auxiliary beam that is directed according to an optical path via the environment including the trajectory of the jet towards the microscopy camera arrangement. Therewith the optical path extends in a direction transverse to the trajectory of the jet to be ejected. An alternative monitoring apparatus may be considered wherein the jet is observed with reflection imagery.

A controller 300 is provided that activates the further optical source 200 with a trigger signal St1, before activating the main optical source 131 with a trigger signal St2. The further optical source 210 may cooperate with a delay element 210 in the optical path to monitor the jet at different points in time. Alternatively or additionally a controllable delay may be achieved by selection of the time interval between the points in time at which the trigger signals St1, St2 are issues. Also a video camera may be employed that upon triggering by the signal St1 records the complete development of the jet in a single cycle. In the embodiment shown, the monitoring apparatus includes additional components 220 to condition the auxiliary beam. In this case a fluorescent element converts the UV-radiation issued by the further auxiliary source 200 into visible radiation. Alternatively, an alternative auxiliary radiation source may be used that renders radiation in the visible spectrum, or a microscopy camera arrangement may be employed that is suitable for UV-imaging. The additional components 220 may further include elements like lenses.

In the embodiment shown in FIG. 2, the apparatus comprises a feed back control unit 310 to adapt a response of the controller 300 to received specification data Ds in accordance with observation data S_{fb}. In the embodiment shown the observation data S_{fb} is jet observation data that is obtained from the camera 240 with which the development of the jet of transferred donor material is observed.

Alternatively or additionally a target monitoring apparatus may be included that provides target observation data indicative for observed properties of deposited donor material on the target surface as observation data.

Experiments were performed using a viscous silver nanoparticle ink with a high metal load. Specifically the ink used has a surface tension of about 35dyn/cm, a metal load of about 70% ww, and a static viscosity of about 6 Pas.

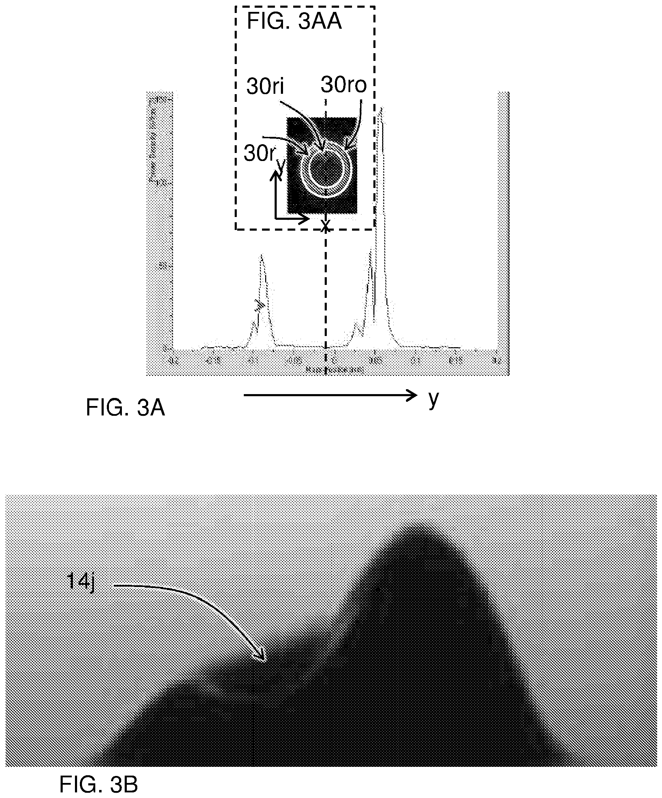

FIG. 3A and FIG. 3AA show an example of an applied intensity profile in more detail. In particular, FIG. 3AA shows an intensity distribution of the radiation beam in the x-y plane coinciding with the donor substrate and the main drawing of FIG. 3A shows the intensity distribution along the dashed line parallel to the y-axis. The intensity is expressed W/cm² and the y-position is indicated in mm. FIG. 3B shows in more detail the jet 14j short after impingement of the beam 30 on the donor material. It is noted that in this case, as will typically be the case, the spatial intensity distribution does not change in the time-interval in which the radiation pulse is applied. Accordingly the energy distribution is simply the product of the intensity distribution and the duration of the time-interval.

In FIG. 3AA it can be seen that the intensity distribution of the optical beam is substantially ring-shaped. In the example shown, the radiation beam ring has a diameter of approximately 150 micron and a width of a approximately 20 micron. As further shown in the main part of FIG. 3A, an asymmetry is present in that the ring beam has an increased intensity in an angular portion delimited between about -25 to about 25 degrees from the y-axis. In the example shown in FIG. 3A, 3AA, the maximum intensity in this region of increased intensity is about 150 W/cm². In the remainder the maximum in the ring is in the ranged of 50 to 60 W/cm².

Upon ejection, the jet 14j of ejected material has a momentum pattern corresponding to the force pattern induced by the optical beam, and as can be seen in FIG. 3B, the jet of ejected material is morphed according to this momentum pattern. Hence, as further illustrated in the examples below, the jet can be controllably directed in a particular direction by generating an optical beam which has an asymmetrical energy distribution in that the energy of the beam is relatively high at a side corresponding to that particular direction. This is surprising, it was found very complicated to control direction in inkjet deposition methods. Therein the effect of the surface tension of the material is of the same order of magnitude as the effect of the momentum pattern (inertia) with which the material is originally ejected. Because the effect of the surface tension of the material is a tendency to direct the ejected material in a direction away from the side of the highest intensity, and these effects are of a comparable strength, a direction control therein is complicated. It could be expected, that due to the small dimensions prevailing in LIFT-processing, in the present application the effect of inertia is even smaller, therewith rendering a direction control impossible. However, as observed above, a clear relationship was found between the asymmetry of the energy distribution of the optical beam and the direction of the jet, whereas the surface tension of the ejected material is only of minor importance in this process.

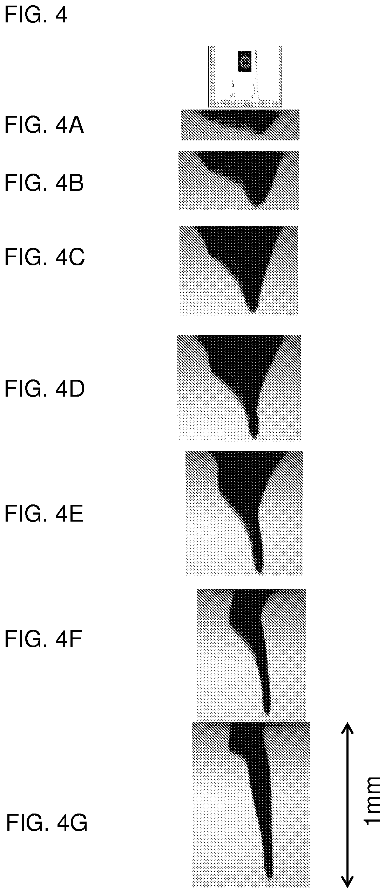

FIG. 4A-4G schematically shows subsequent stages of development of a jet of ejected viscous donor material resulting from exposure to a radiation beam having an intensity profile as shown in FIG. 4. FIG. 4A-4G are micrograph pictures taken respectively at 5µs, 10µs, 15µs, 20µs, 25µs, 30µs, 35µs after the point in time the exposure took place. The micrograph pictures are obtained with the arrangement presented in FIG. 2. As can be seen in this sequence of figures FIG. 4A-4G, the donor material can ejected from a relatively surface area of the donor surface and controllably directed to a relatively small surface are on the target. Therewith it is also rendered possible to transfer the donor material as long jets bridging a distance up to a few cm between the donor substrate and the target substrate. This enables a broad range of applications, ranging from face-up integration of thin and relatively thick components to conformal printing.

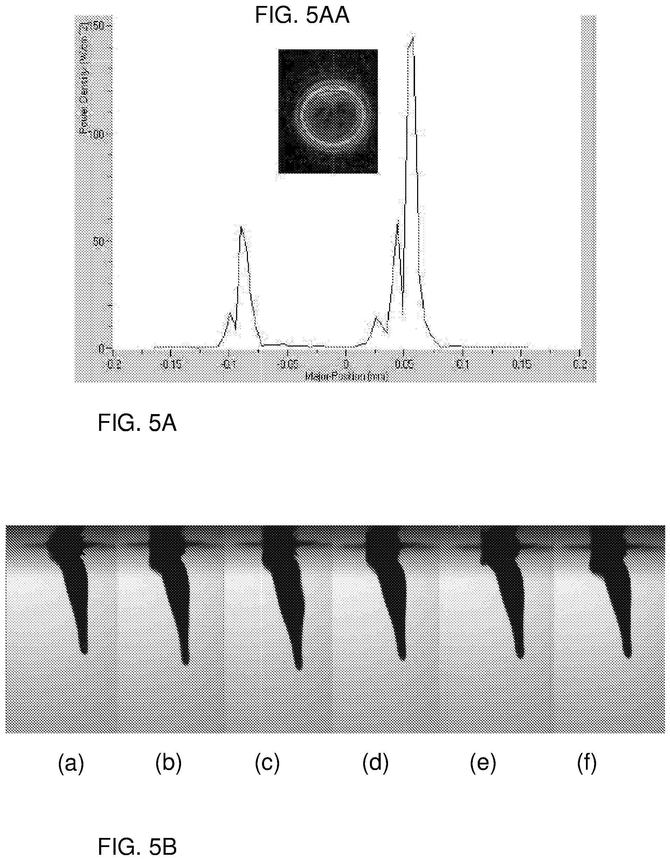

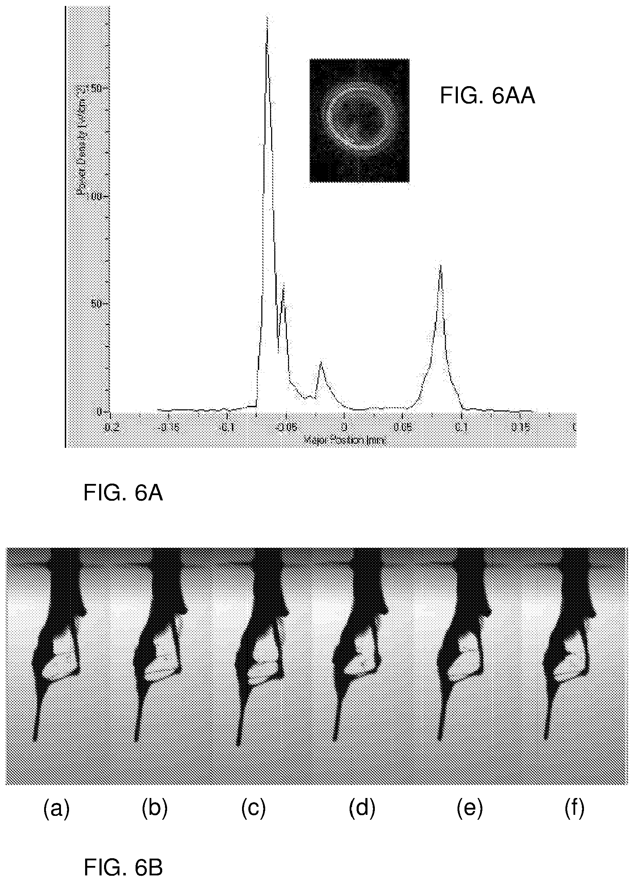

A shown in FIG. 5A, 5AA, 5B and FIG. 6A, 6AA, and 6B, the shape of the jet, and therewith the pattern with which the donor material is deposited can be reproducibly controlled by the energy distribution.

As a first example FIG. 5A, FIG. 5AA show again the energy distribution like that in FIG. 3A, 3AA which is repeatedly applied in a series of experiments (a) - (f). FIG. 5B shows for each of these experiments the jet of donor material that is observed a point in time 35µs after exposure to the optical beam. As can be seen in these series of micrographs hardly any variance of the shape of the jet is visible.

As a second example FIG. 6A, FIG. 6AA show another energy distribution using the same representation and scale as the one in FIG. 3A, 3AA which is also repeatedly applied in a series of experiments (a) - (f). FIG. 6B shows for each of these experiments the jet of donor material that is observed a point in time 35µs after exposure to the optical beam. As can be seen in these series of micrographs the very rugged shape of the jet is accurately reproduced.

In summary, in operation of a device as claimed a deposition method is executed. Therein a donor substrate 10 is arranged opposite a target substrate 20. The donor substrate 10 has a surface 12 facing the target substrate 20 that is provided with a viscous donor material 14. The donor material 14 has viscoelastic properties, in particular at an elevated temperature. Having the donor substrate 10 and the target substrate 20 so arranged, an optical beam 30 is generated, and directed via the donor substrate 10 to the donor material 14 so as to release the donor material and transfer the donor material as a jet 14j towards the target substrate. In the claimed method, an input signal is received that specifies a shape to be assumed by the jet in which the donor material is to be transferred and an energy profile of the optical beam is controlled based on the specified shape. Alternatively or in addition an energy profile of the optical beam may be controlled based on specifications for a pattern in which donor material is to be deposited on the target substrate.

While the invention has been illustrated and described in detail in the drawings and foregoing description, such illustration and description are to be considered illustrative or exemplary and not restrictive; the invention is not limited to the disclosed embodiments.

## Claims

1. A deposition apparatus (100) to deposit donor material (14) having viscous properties from a donor surface (12) of a donor substrate (10) on a target surface (22) of a target substrate (20), the apparatus comprising:
- a target substrate carrier (120) to carry the target substrate (20) and a donor substrate carrier (110) to carry the donor substrate (10) opposite the target substrate (20) with the donor surface (12) and the target surface (22) facing each other;
- an optical beam generator (130) to generate an optical beam (30) to be directed through the donor substrate (10) towards the donor material (14), the optical beam having an optical axis (32) with a point of intersection (34) in the target surface (22);
- a positioning device (150) to control a position of the point of intersection (34);
- a controller (160) to control operation of the optical beam generator (130), and to control the positioning device (150),
wherein in an operational state of the deposition apparatus (100), the controller (160) is configured to receive specification data (DS) specifying a desired spatial distribution of donor material on the target surface (22), wherein the controller (160) generates a position control signal (S140,S150) to control the positioning device, and a beam generator control signal (S130) to control operation of the optical beam generator in accordance with said desired spatial distribution, and wherein the optical beam generator (130) generates the optical beam (30) in response to the beam generator control signal to cause donor material to be transferred from the donor surface (12) towards a position on the target surface (22) dependent on the position control signal (S140,S150);
wherein the optical beam generator (130) is further configured to generate the optical beam (30) to eject a portion of donor material with a controllable spatial energy distribution and in that the controller (160) is configured to generate the beam generator control signal (S130) in accordance with the received specification data (DS) to control the spatial energy distribution, **characterized in that** the optical beam generator (130) is configured to generate an optical beam that results in a transfer of the donor material as a jet, the controller (160) being configured to control the optical beam generator (130) to generate the optical beam with a substantially asymmetric spatial distribution on the basis of a shape to be assumed by the jet according to said specification data.

2. The deposition apparatus according to claim 1, wherein the controller (160) is configured to issue a beam generator control signal (S130) that causes the optical beam generator (130) to generate the optical beam with a spatial energy distribution that has a higher average energy density in a ring shaped zone (30r) around its optical axis than an average energy density within an inner boundary (30ri) of the ring shaped zone.

3. The deposition apparatus according to one of the previous claims, wherein the optical beam generator comprises a source of optical radiation (131) and a beam shaper (134, 135).

4. The deposition apparatus according to claim 3, wherein the beam shaper includes a pair of a first and a second axicon (134, 135).

5. The apparatus according to one of the previous claims, further comprising a feed back control unit (310) to adapt a response of the controller (300) to received specification data in accordance with observation data.

6. The apparatus according to claim 5, further comprising a jet monitoring apparatus that provides jet observation data indicative for an observed development of the jet of transferred donor material as observation data.

7. The apparatus according to claim 5 or 6, further comprising a target monitoring apparatus that provides target observation data indicative for observed properties of deposited donor material on the target surface as observation data.

8. A deposition method comprising the steps of:
- arranging a donor substrate opposite a target substrate, the donor substrate having a surface facing the target substrate that is provided with a viscous donor material, the donor material having viscoelastic properties at an elevated temperature,
- generating an optical beam, and directing the optical beam via the donor substrate to the donor material so as to release the donor material and transfer the donor material towards the target substrate,
- receiving an input signal and controlling an energy profile of the optical beam based on said input signal; **characterized by**:
- generating the optical beam to transfer the donor material as a jet, the optical beam being controllably generated with a substantially asymmetric spatial distribution based on a shape to assumed by the jet according to a specification in said input signal.

9. The deposition method according to claim 8, wherein the donor material is a shear-thinning substance.

10. The deposition method according to claim 8 or 9, further comprising obtaining jet observation data indicative for an observed development of the jet of transferred donor material, and controlling an intensity profile of the optical beam based on a difference between a shape of the jet as specified by the input signal and a shape of the jet as indicated by the jet observation data.

11. The deposition method according to claim 8, 9 or 10, further comprising obtaining target observation data indicative for observed properties of deposited donor material on the target surface, and controlling an intensity profile of the optical beam based on a difference between a pattern of deposited material specified by the input signal and a pattern of deposited material as indicated by the target observation data.

## Patentansprüche

1. Abscheidungseinrichtung (100) zum Abscheiden von Donormaterial (14) mit viskosen Eigenschaften von einer Donoroberfläche (12) eines Donorsubstrats (10) auf einer Zieloberfläche (22) eines Zielsubstrats (20), wobei die Einrichtung umfasst:
- einen Zielsubstratträger (120) zum Tragen des Zielsubstrats (20) und einen Donorsubstratträger (110) zum Tragen des Donorsubstrats (10) gegenüber dem Zielsubstrat (20), wobei die Donoroberfläche (12) und die Zieloberfläche (22) einander gegenüberliegen;
- einen optischen Strahlgenerator (130) zum Erzeugen eines optischen Strahls (30), der durch das Donorsubstrat (10) auf das Donormaterial (14) gerichtet werden soll, wobei der optische Strahl eine optische Achse (32) mit einem Schnittpunkt (34) in der Zieloberfläche (22) aufweist;
- eine Positioniervorrichtung (150) zur Steuerung einer Position des Schnittpunkts (34);
- eine Steuerung (160) zum Steuern des Betriebs des optischen Strahlgenerators (130) und zum Steuern der Positioniervorrichtung (150), wobei
in einem Betriebszustand der Abscheidungseinrichtung (100) die Steuerung (160) so ausgelegt ist, dass sie Spezifikationsdaten (DS) empfängt, die eine gewünschte räumliche Verteilung von Donormaterial auf der Zieloberfläche (22) spezifizieren, wobei die Steuerung (160) ein Positionssteuersignal (S140,S150) zum Steuern der Positioniervorrichtung und ein Strahlgeneratorsteuersignal (S130) zum Steuern des Betriebs des optischen Strahlgenerators in Übereinstimmung mit der gewünschten räumlichen Verteilung erzeugt, und wobei der optische Strahlgenerator (130) den optischen Strahl (30) als Reaktion auf das Strahlgeneratorsteuersignal erzeugt, um zu bewirken, dass Donormaterial von der Donoroberfläche (12) zu einer Position auf der Zieloberfläche (22) in Abhängigkeit von dem Positionssteuersignal (S140,S150) übertragen wird;
wobei der optische Strahlgenerator (130) ferner so ausgelegt ist, dass er den optischen Strahl (30) erzeugt, um einen Teil des Donormaterials mit einer steuerbaren räumlichen Energieverteilung auszustoßen, und dass die Steuerung (160) so ausgelegt ist, dass sie das Strahlgeneratorsteuersignal (S130) in Übereinstimmung mit den empfangenen Spezifikationsdaten (DS) erzeugt, um die räumliche Energieverteilung zu steuern, **dadurch gekennzeichnet, dass** der optische Strahlgenerator (130) so ausgelegt ist, dass er einen optischen Strahl erzeugt, der zu einer Übertragung des Donormaterials als Strahl führt, wobei die Steuerung (160) so ausgelegt ist, dass sie den optischen Strahlgenerator (130) so steuert, dass er den optischen Strahl mit einer im Wesentlichen asymmetrischen räumlichen Verteilung auf der Grundlage einer Form erzeugt, die der Strahl nach den Spezifikationsdaten annehmen soll.

2. Abscheidungseinrichtung nach Anspruch 1, wobei die Steuerung (160) so ausgelegt ist, dass sie ein Strahlgeneratorsteuersignal (S130) ausgibt, das bewirkt, dass der optische Strahlgenerator (130) den optischen Strahl mit einer räumlichen Energieverteilung erzeugt, die in einer ringförmigen Zone (30r) um ihre optische Achse eine höhere durchschnittliche Energiedichte aufweist als eine durchschnittliche Energiedichte innerhalb einer inneren Begrenzung (30ri) der ringförmigen Zone.

3. Abscheidungseinrichtung nach einem der vorhergehenden Ansprüche, wobei der optische Strahlgenerator eine optische Strahlungsquelle (131) und einen Strahlformer (134, 135) umfasst.

4. Abscheidungseinrichtung nach Anspruch 3, wobei der Strahlformer ein Paar aus einem ersten und einem zweiten Axikon (134, 135) einschließt.

5. Einrichtung nach einem der vorhergehenden Ansprüche, die ferner eine Rückkopplungssteuereinheit (310) umfasst, um eine Reaktion der Steuerung (300) auf empfangene Spezifikationsdaten in Übereinstimmung mit Beobachtungsdaten anzupassen.

6. Einrichtung nach Anspruch 5, die ferner eine Strahlüberwachungseinrichtung umfasst, die Strahlbeobachtungsdaten bereitstellt, die eine beobachtete Entwicklung des Strahls des übertragenen Donormaterials als Beobachtungsdaten angeben.

7. Einrichtung nach Anspruch 5 oder 6, die ferner eine Zielüberwachungseinrichtung umfasst, die Zielbeobachtungsdaten bereitstellt, die auf beobachtete Eigenschaften des auf der Zieloberfläche abgeschiedenen Donormaterials als Beobachtungsdaten angeben.

8. Abscheidungsverfahren, das die Schritte umfasst:
- Anordnen eines Donorsubstrats gegenüber einem Zielsubstrat, wobei das Donorsubstrat eine dem Zielsubstrat gegenüberliegende Oberfläche aufweist, die mit einem viskosen Donormaterial versehen ist, wobei das Donormaterial bei einer erhöhten Temperatur viskoelastische Eigenschaften aufweist,
- Erzeugen eines optischen Strahls und Richten des optischen Strahls über das Donorsubstrat auf das Donormaterial, um das Donormaterial freizusetzen und das Donormaterial auf das Zielsubstrat zu übertragen,
- Empfangen eines Eingangssignals und Steuern eines Energieprofils des optischen Strahls basierend auf dem Eingangssignal; **gekennzeichnet durch**:
- Erzeugen des optischen Strahls, um das Donormaterial als Strahl zu übertragen, wobei der optische Strahl steuerbar mit einer im Wesentlichen asymmetrischen räumlichen Verteilung erzeugt wird, die auf einer Form basiert, die der Strahl nach einer Spezifikation in dem Eingangssignal annehmen soll.

9. Abscheidungsverfahren nach Anspruch 8, wobei das Donormaterial eine scherverdünnende Substanz ist.

10. Abscheidungsverfahren nach Anspruch 8 oder 9, ferner umfassend das Erhalten von Strahlbeobachtungsdaten, die eine beobachtete Entwicklung des Strahls aus übertragenem Donormaterial angeben, und das Steuern eines Intensitätsprofils des optischen Strahls basierend auf einer Differenz zwischen einer Form des Strahls, wie sie durch das Eingangssignal spezifiziert ist, und einer Form des Strahls, wie sie durch die Strahlbeobachtungsdaten angegeben wird.

11. Abscheidungsverfahren nach Anspruch 8, 9 oder 10, ferner umfassend das Erhalten von Zielbeobachtungsdaten, die beobachtete Eigenschaften des abgeschiedenen Donormaterials auf der Zieloberfläche angeben, und das Steuern eines Intensitätsprofils des optischen Strahls basierend auf einer Differenz zwischen einem Muster des abgeschiedenen Materials, das durch das Eingangssignal spezifiziert ist, und einem Muster des abgeschiedenen Materials, wie es durch die Zielbeobachtungsdaten angegeben wird.

## Revendications

1. Appareil de dépôt (100) pour déposer un matériau donneur (14) ayant des propriétés visqueuses à partir d'une surface de donneur (12) d'un substrat donneur (10) sur une surface de cible (22) d'un substrat cible (20), l'appareil comprenant :
- un support de substrat cible (120) pour supporter le substrat cible (20) et un support de substrat donneur (110) pour supporter le substrat donneur (10) faisant face au substrat cible (20) avec la surface de donneur (12) et la surface de cible (22) en face l'une de l'autre ;
- un générateur de faisceau optique (130) pour générer un faisceau optique (30) devant être dirigé à travers le substrat donneur (10) sur le matériau donneur (14), le faisceau optique ayant un axe optique (32) avec un point d'intersection (34) dans la surface de cible (22) ;
- un dispositif de positionnement (150) pour commander une position du point d'intersection (34) ;
- un dispositif de commande (160) pour commander le fonctionnement du générateur de faisceau optique (130) et pour commander le dispositif de positionnement (150),
dans lequel, dans un état opérationnel de l'appareil de dépôt (100), le dispositif de commande (160) est configuré pour recevoir des données de spécification (DS) spécifiant une distribution spatiale souhaitée de matériau donneur sur la surface de cible (22), dans lequel le dispositif de commande (160) génère un signal de commande de position (S140,S150) pour commander le dispositif de positionnement, et un signal de commande de générateur de faisceau (S 130) pour commander le fonctionnement du générateur de faisceau optique conformément à ladite distribution spatiale souhaitée, et dans lequel le générateur de faisceau optique (130) génère le faisceau optique (30) en réponse au signal de commande de générateur de faisceau afin d'amener le matériau donneur à être transféré de la surface de donneur (12) vers une position sur la surface de cible (22) en fonction du signal de commande de position (S140,S150) ;
dans lequel le générateur de faisceau optique (130) est en outre configuré pour générer le faisceau optique (30) afin d'éjecter une partie du matériau donneur avec une distribution d'énergie spatiale pouvant être commandée et en ce que le dispositif de commande (160) est configuré pour générer le signal de commande de générateur de faisceau (S 130) conformément aux données de spécification reçues (DS) afin de commander la distribution d'énergie spatiale, **caractérisé en ce que** le générateur de faisceau optique (130) est configuré pour générer un faisceau optique qui résulte en un transfert du matériau donneur sous la forme d'un jet, le dispositif de commande (160) étant configuré pour commander le générateur de faisceau optique (130) afin de générer le faisceau optique avec une distribution spatiale sensiblement asymétrique sur la base d'une forme devant être prise par le jet conformément auxdites données de spécification.

2. Appareil de dépôt selon la revendication 1, dans lequel le dispositif de commande (160) est configuré pour émettre un signal de commande de générateur de faisceau (S 130) qui amène le générateur de faisceau optique (130) à générer le faisceau optique avec une distribution d'énergie spatiale qui a une densité d'énergie moyenne dans une zone en forme d'anneau (30r) autour de son axe optique supérieure à une densité d'énergie moyenne à l'intérieur d'une limite interne (30ri) de la zone en forme d'anneau.

3. Appareil de dépôt selon l'une quelconque des revendications précédentes, dans lequel le générateur de faisceau optique comprend une source de rayonnement optique (131) et un dispositif de mise en forme de faisceau (134, 135).

4. Appareil de dépôt selon la revendication 3, dans lequel le dispositif de mise en forme de faisceau comprend une paire d'un premier et d'un second axicon (134, 135).

5. Appareil selon l'une des revendications précédentes, comprenant en outre une unité de commande de rétroaction (310) pour adapter une réponse du dispositif de commande (300) à des données de spécification reçues en fonction de données d'observation.

6. Appareil selon la revendication 5, comprenant en outre un appareil de surveillance de jet qui fournit des données d'observation de jet indicatives d'un développement observé du jet de matériau donneur transféré en tant que données d'observation.

7. Appareil selon la revendication 5 ou 6, comprenant en outre un appareil de surveillance de cible qui fournit des données d'observation de cible indicatives de propriétés observées du matériau donneur déposé sur la surface de cible en tant que données d'observation.

8. Procédé de dépôt comprenant les étapes consistant à :
- agencer un substrat donneur en face d'un substrat cible, le substrat donneur ayant une surface faisant face au substrat cible qui est munie d'un matériau donneur visqueux, le matériau donneur ayant des propriétés viscoélastiques à une température élevée,
- générer un faisceau optique, et diriger le faisceau optique via le substrat donneur vers le matériau donneur de manière à libérer le matériau donneur et à transférer le matériau donneur vers le substrat cible,
- recevoir un signal d'entrée et commander un profil d'énergie du faisceau optique sur la base dudit signal d'entrée ; **caractérisé par** l'étape consistant à :
- générer le faisceau optique pour transférer le matériau donneur sous la forme d'un jet, le faisceau optique étant généré de manière commandée avec une distribution spatiale sensiblement asymétrique basée sur une forme devant être prise par le jet selon une spécification dans ledit signal d'entrée.

9. Procédé de dépôt selon la revendication 8, dans lequel le matériau donneur est une substance à amincissement par cisaillement.

10. Procédé de dépôt selon la revendication 8 ou 9, comprenant en outre une obtention de données d'observation de jet indicatives d'un développement observé du jet de matériau donneur transféré, et une commande d'un profil d'intensité du faisceau optique sur la base d'une différence entre une forme du jet telle que spécifiée par le signal d'entrée et une forme du jet telle qu'indiquée par les données d'observation de jet.

11. Procédé de dépôt selon la revendication 8, 9 ou 10, comprenant en outre une obtention de données d'observation de cible indicatives de propriétés observées du matériau donneur déposé sur la surface de cible, et une commande d'un profil d'intensité du faisceau optique sur la base d'une différence entre un motif de matériau déposé spécifié par le signal d'entrée et un motif de matériau déposé tel qu'indiqué par les données d'observation de cible.
